(19) Europäisches Patentamt
European Patent Office
Office européen des brevets

(11) EP 4 067 449 B1

(12) **EUROPEAN PATENT SPECIFICATION**

(45) Date of publication and mention of the grant of the patent:
**20.05.2026 Bulletin 2026/21**

(21) Application number: **22166299.2**

(22) Date of filing: **01.04.2022**

(51) International Patent Classification (IPC):
***C09G 1/02*** *(2006.01)*

(52) Cooperative Patent Classification (CPC):
**C09G 1/02**

(54) **POLISHING COMPOSITION FOR SEMICONDUCTOR PROCESS AND METHOD FOR MANUFACTURING SEMICONDUCTOR DEVICE BY USING THE SAME**

POLIERZUSAMMENSETZUNG FÜR EINEN HALBLEITERPROZESS UND VERFAHREN ZUR HERSTELLUNG EINES HALBLEITERBAUELEMENTS DAMIT

COMPOSITION DE POLISSAGE POUR PROCÉDÉ DE SEMI-CONDUCTEUR ET PROCÉDÉ DE FABRICATION D'UN DISPOSITIF SEMI-CONDUCTEUR À L'AIDE DE CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.04.2021 KR 20210043575**
**31.03.2022 KR 20220040010**

(43) Date of publication of application:
**05.10.2022 Bulletin 2022/40**

(73) Proprietor: **Ycchem Co., Ltd.**
**Gyeongsangbuk-do 40046 (KR)**

(72) Inventors:
- **HONG, Seung Chul**
  **03142 Seoul (KR)**
- **HAN, Deok Su**
  **03142 Seoul (KR)**
- **PARK, Han Teo**
  **03142 Seoul (KR)**
- **KWON, Jang Kuk**
  **03142 Seoul (KR)**

(74) Representative: **BCKIP Part mbB**
**MK1**
**Landsbergerstraße 98, 3.Stock**
**80339 München (DE)**

(56) References cited:
**EP-A1- 3 597 711** **EP-A1- 3 628 714**
**US-A1- 2020 172 763**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 067 449 B1

## Description

### Technical Field

The present disclosure relates to a polishing composition for a semiconductor process and a method for manufacturing a semiconductor device by using the polishing composition.

### Background Art

In accordance with more miniaturization and an increase in density in a semiconductor device, techniques for forming finer patterns are being used, and accordingly, a surface structure of a semiconductor device becomes more complicated, and a step difference between interlayer films is also increasing. A semiconductor device is manufactured using a chemical mechanical polishing (hereinafter referred to as "CMP") process as a planarization technology for removing a step difference in a specific layer formed on a substrate.

In the CMP process, as slurry is supplied to a polishing pad, the substrate is pressed and rotated, and the surface is polished. An object to be planarized is changed depending on a stage in a process, and in this case, there is also a difference in physical properties of applied slurry.

Specifically, the CMP process has been applied to a planarization process of dielectric materials such as a silicon oxide ($SiO_2$) layer and a silicon nitride (SiN) layer, and is also essentially used for a planarization process for a metal wiring made of tungsten (W), copper (Cu), etc.

Tungsten barrier metal layer CMP is a CMP process in which three layers appear simultaneously, such as a silicon oxide ($SiO_2$) layer and a titanium/titanium nitride layer used as a barrier metal layer as well as a tungsten (W) layer.

A high level of technology is required to not only polish the three layers according to a desired selection ratio, but also to ensure performance of reducing the level of dishing and defects. US 2020/172763 A1 describes a polishing slurry composition comprising a dialkyldiallylammonium halide, a basic amino acid, a non-ionic surfactant, and a pH adjuster.

DISCLOSURE

Technical Problem

An object of the present disclosure is to provide to a polishing composition for a semiconductor process and a method for manufacturing a semiconductor device by using the polishing composition.

Another object of the present disclosure is to prevent polishing particles from being re-adsorbed on the wafer during the polishing process to prevent wafer defects, and to provide a polishing composition for a semiconductor process with improved polishing rate, selectivity, and dispersibility.

Still another object of the present disclosure is to provide a method for manufacturing a semiconductor device by using the polishing composition for a semiconductor process.

### Technical Solution

The invention is defined by the appended claims. In an aspect, in a polishing composition for a semiconductor process,100 ml of the polishing composition is mixed and diluted with ultrapure water in a weight ratio of 1:30, wherein the diluted polishing composition has a value of 0.01 to 0.14 according to the following Equation 1 as measured by a large particle counter (LPC):

[Equation 1]

$$\frac{X \times 500A}{Y \times P}$$

wherein

X is the number of particles having a diameter of 1 $\mu$m or more as measured by LPC,

Y is the number of particles having a diameter of 0.7 μm or more as measured by LPC,

P is a weight part of the polishing particles based on 100 parts by weight of the solvent of the polishing composition for a semiconductor process, and

A is a weight part of a surfactant based on 100 parts by weight of a solvent of the polishing composition for a semiconductor process.

In another example of the present disclosure, a method for manufacturing a semiconductor device includes: 1) providing a polishing pad including a polishing layer; 2) supplying a polishing composition for a semiconductor process to the polishing pad; and 3) polishing a polishing object while rotating the polishing object and the polishing layer relative to each other so that a polished surface of the polishing object is in contact with a polishing surface of the polishing layer.

**Advantageous Effects**

The polishing composition for a semiconductor process of the present disclosure prevents the polishing particles from being re-adsorbed on a wafer during a polishing process to prevent wafer defects, and improves polishing rate, selectivity, and dispersibility.

In addition, when a semiconductor device is manufactured by applying the polishing composition for a semiconductor process, polarization is possible with an excellent selectivity even on a surface on which all of tungsten, a diffusion barrier layer, and an insulating layer exist.

**Brief Description of Drawings**

FIG. 1 is a result of a detection experiment of fungi and cultured bacteria according to an embodiment of the present disclosure.

FIG. 2 is a result of a detection experiment of fungi and cultured bacteria according to an embodiment of the present disclosure.

FIG. 3 is a schematic process diagram of a method for manufacturing a semiconductor device according to an embodiment of the present disclosure.

**Best Mode**

Hereinafter, embodiments of the present disclosure will be described in detail so as to be easily carried out by those of ordinary skill in the art to which the present disclosure pertains. However, the present disclosure may be implemented in various different forms and is not limited to examples described herein.

As used herein, when any component is referred to as "including" another component, it means the inclusion of other components rather than the exclusion of other components, unless explicitly described to the contrary.

As used herein, when any component is referred to as being "connected to" another component, it means that any component and another component are "directly connected to" each other or are "connected to" each other with the other component interposed therebetween.

As used herein, "B is located on A" means that B is located directly on A or B is located on A while another layer is located therebetween and is not construed as being limited to locating B in contact with the surface of A.

As used herein, the term "combinations thereof" included in the expression of a Markush-type refers to one or more mixtures or combinations selected from the group consisting of the components described in the expression of the Markush-type, which include one or more selected from the group consisting of the above components.

As used herein, the description of "A and/or B" means "A, B, or A and B."

As used herein, terms such as "first" and "second" or "A" and "B" are used to distinguish the same terms from each other unless otherwise specified.

As used herein, the singular expression is to be construed as meaning including the singular or the plural as interpreted in context unless otherwise specified.

As used herein, "hydrogen" is hydrogen, protium, deuterium, or tritium.

As used herein, "alkyl" refers to a monovalent substituent derived from a straight or branched chain, saturated hydrocarbon having 1 to 40 carbon atoms. Examples of the alkyl include, but are not limited to, methyl, ethyl, propyl,

isobutyl, sec-butyl, pentyl, iso-amyl, hexyl, etc.

As used herein, "alkenyl" refers to a monovalent substituent derived from a straight or branched chain, unsaturated hydrocarbon having 2 to 40 carbon atoms and having one or more carbon-carbon double bonds. Examples of the alkenyl include, but are not limited to, vinyl, allyl, isopropenyl, 2-butenyl, etc.

As used herein, "alkynyl" refers to a monovalent substituent derived from a straight or branched chain, unsaturated hydrocarbon having 2 to 40 carbon atoms and having one or more carbon-carbon triple bonds. Examples of the alkynyl include, but are not limited to, ethynyl, 2-propynyl, etc.

As used herein, "cycloalkyl" refers to a monovalent substituent derived from a monocyclic or polycyclic non-aromatic hydrocarbon having 3 to 40 carbon atoms. Examples of the cycloalkyl include, but are not limited to, cyclopropyl, cyclobutyl, cyclopentyl, cyclohexyl, norbornyl, adamantine, etc.

Hereinafter, the present disclosure will be described in detail.

In a polishing composition for a semiconductor process according to an embodiment of the present disclosure, 100 ml of the polishing composition is mixed and diluted with ultrapure water in a weight ratio of 1:30, wherein the diluted polishing composition has a value of 0.01 to 0.14 according to the following Equation 1 as measured by large particle counter (LPC):

[Equation 1]

$$\frac{X \times 500A}{Y \times P}$$

wherein

X is the number of particles having a diameter of 1 μm or more as measured by LPC,

X is the number of particles having a diameter of 0.7 μm or more as measured by LPC,

P is a weight part of the polishing particles based on 100 parts by weight of the solvent of the polishing composition for a semiconductor process,

A is a weight part of a surfactant based on 100 parts by weight of a solvent of the polishing composition for a semiconductor process.

The LPC measurement may be performed according to the following principle.

While the diluted composition flows at a constant rate, the diameter and number of particles included in the diluted composition may be measured by an optical method. As an example of the optical method, there is a method of measuring the size and number of particles by measuring the total amount of laser, etc. absorbed and reflected by particles.

The polishing composition for a semiconductor process is used in a planarization process for dielectric materials such as a silicon oxide ($SiO_2$) layer and a silicon nitride (SiN) layer, and a metal wiring made of tungsten (W) or copper (Cu), etc. In the case of tungsten barrier metal layer CMP, the polishing composition for a semiconductor process may be used as a slurry for simultaneously polishing three layers such as a silicon oxide ($SiO_2$) layer and a titanium/titanium nitride layer used as a barrier metal layer as well as a tungsten (W) layer.

As described above, it is necessary for the polishing composition to exhibit a polishing rate suitable for the process for the layer of various materials, as well as to minimize defects on the surface of the wafer to be polished.

Specifically, when the polishing rate is increased by using the polishing composition, an effect of improving a polishing speed, etc. may be exhibited, but defects on the wafer should be minimized while improving the polishing rate.

In order to improve such dispersibility, a surfactant is included, and the content of the surfactant enables the polishing particles to be uniformly mixed in the composition, and prevents agglomeration between particles, thereby reducing a defect on the surface of a wafer according to the increase in particle size.

Equation 1 of the present disclosure means a calculated value according to the relationship between the number of polishing particles having a particle size of 0.7 μm or more and the number of polishing particles having a particle size of 1 μm or more according to the LPC measurement result for the polishing composition, and the content of the surfactant included in the polishing composition, wherein the value of Equation 1 may be 0.01 to 0.14, 0.02 to 0.13, 0.03 to 0.10, and 0.04 to 0.09. The value of Equation 1 is a value for a case where the content of the polishing particles in the polishing

composition is matched in the same range and the value of the surfactant is changed, and as described above, the effect according to the content of the surfactant may be clearly confirmed.

Although a small amount of the surfactant is included, it is possible to prevent aggregation between the polishing particles in the polishing composition and to increase dispersibility.

In addition, as will be described later, the surfactant of the present disclosure replaces the surface charge of the polishing particles in order to improve the polishing performance of the particles, so that the polishing performance with the layer may be relatively improved. However, a large amount of polishing particles may be adsorbed on the surface of the layer due to a difference in electric charge between the layer and the polishing particles, but this problem may be prevented by the surfactant of the present disclosure.

Specifically, the surfactant of the present disclosure may be included in a small amount in the polishing composition to improve dispersibility between particles and to prevent a problem of re-adsorption with the layer.

According to these characteristics, when the value according to Equation 1 is included within the scope of the present disclosure, the effect may be corrected according to the addition of small amount by including it as a value multiplied by a specific coefficient.

When the value according to Equation 1 is included within the scope of the present disclosure, the polishing rate for the layer is excellent, the polishing selectivity may be improved, and the effect of preventing defects in the wafer may be enhanced.

As described above, as for the size of the polishing particles in the polishing composition, the larger the particle diameter, the higher the polishing rate, but the relative defects of the wafer may increase.

Accordingly, in addition to the improvement of the polishing rate, it is necessary to distribute the particle size at an appropriate level to prevent defects in the wafer, and when the value according to Equation 1 is included within the scope of the present disclosure, the polishing rate for the layer may be increased, In addition, it is possible to prevent defects of the wafer.

The polishing particles are polishing particles that may be applied to a polishing composition for a semiconductor process, and for example, may be selected from the group consisting of metal oxides, organic particles, organic-inorganic composite particles, and a mixture thereof. The metal oxide may be selected from the group consisting of colloidal silica, fumed silica, ceria, alumina, titania, zirconia, zeolite, and a mixture thereof, but is not limited thereto, and all polishing particles that may be selected by those skilled in the art may be used without limitation.

The organic particles include polystyrene, styrene-based copolymer, poly(meth)acrylate, (meth)acrylate copolymer, polyvinyl chloride, polyamide, polycarbonate, polyimide polymer; or particles with a core/shell structure in which the polymer constitutes a core, a shell, or both. Also, the organic particles may be used alone or in combination, and may be prepared by emulsion polymerization, suspension polymerization, etc.

The polishing particles according to the present disclosure may be specifically selected from the group consisting of colloidal silica, fumed silica, ceria, and a mixture thereof.

The polishing particles are included in an amount of 1 to 15 parts by weight, 2 to 12 parts by weight, and 2 to 10 parts by weight based on 100 parts by weight of the solvent. When the polishing particles are included in the above content range, both dispersion stability and the effect of reducing defects on the surface of the polished substrate may be obtained.

The polishing particles of the present disclosure include a functional group bonded to the particle surface, and the functional group includes a terminal amine group.

By modifying the surface of the polishing particles to bond amine compounds, it is possible to increase the polishing rate for the layer, improve the polishing selectivity, and prevent wafer defects that may occur during the polishing process.

Specifically, in the case of colloidal silica, a silane compound is generally used to modify the surface of the particle. Among these silanes, in the case of a silane substituted with an amine group, a high level of negative charge may be substituted with a certain level of positive charge. In general, colloidal silica is used as polishing particles in the tungsten (W) polishing process, but the surface charge of colloidal silica itself shows a high level of negative charge. Thus, it is known that the physical polishing ability is low due to the electrostatic repulsive force acting when reacting with the silicon oxide ($SiO_2$) layer.

In the present disclosure, in order to solve this problem, a silane compound is bonded to the surface of the colloidal silica, the negative chare is replaced with a certain level of positive charge, and thus, the polishing rate of the silicon oxide may be increased.

Specifically, for surface modification of colloidal silica, it is reacted with an amino silane compound to increase the polishing rate of the silicon oxide layer and prevent the occurrence of defects on the wafer surface.

When amino silane is bonded to the particle surface of the colloidal silica, it may be bonded to the following functional group:

[Formula 1]

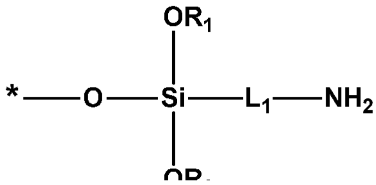

wherein

* means a portion boned to the surface of the polishing particles, $R_1$ and $R_2$ are the same as or different from each other, and are each independently selected from the group consisting of hydrogen, a substituted or unsubstituted alkyl group having 1 to 10 carbon atoms, a substituted or unsubstituted cycloalkyl group having 3 to 10 carbon atoms, a substituted or unsubstituted alkenyl group having 2 to 10 carbon atoms, and a substituted or unsubstituted alkynyl group having 2 to 10 carbon atoms, and $L_1$ is selected from the group consisting of a substituted or unsubstituted alkylene group having 1 to 10 carbon atoms, a substituted or unsubstituted alkenylene group having 2 to 10 carbon atoms, a substituted or unsubstituted alkynylene group having 2 to 10 carbon atoms, and a substituted or unsubstituted cycloalkylene group having 3 to 10 carbon atoms.

Specifically, $R_1$ and $R_2$ are the same as or different from each other, and may be each independently an alkyl group having 1 to 10 carbon atoms, and L1 may be a substituted or unsubstituted alkylene group having 1 to 10 carbon atoms.

The amino silane may be, for example, any one selected from the group consisting of 3-aminopropyltriethoxysilane, bis[(3-triethoxysilyl)propyl]amine, 3-aminopropyltrimethoxysilane, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine, N-bis [3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, N-[3-(trimethoxysilyl)propyl]butylamine, and combinations thereof.

Specifically, the amino silane used for surface modification of colloidal silica may be aminopropyltriethoxysilane, but the present disclosure is not limited to the above example, and any amino silanes capable of having excellent polishing rate of boron-doped silicon wafers and preventing surface defects may be used without limitation.

The polishing particles and the amino silane compound may be included in a weight ratio of 1:0.005 to 1:0.05, a weight ratio of 1:0.008 to 1:0.04, and a weight ratio of 1:0.01 to 1:0.035. In addition, the amino silane is more specifically included in an amount of 0.10 parts by weight to 0.5 parts by weight, 0.15 parts by weight to 0.3 parts by weight, and 0.15 parts by weight to 0.25 parts by weight based on 100 parts by weight of the solvent. When the polishing particles and the amino silane compound are included in a weight ratio within the above range, the amino silane compound may be bonded to the surface of the polishing particles, thereby exhibiting an excellent polishing rate for the silicon oxide layer, and preventing the occurrence of defects such as defect during the polishing process.

The metal oxide particles may have a diameter ($D_{50}$) of 10 to 120 nm, preferably a diameter ($D_{50}$) of 20 to 100 nm, and more preferably a diameter ($D_{50}$) of 20 to 60 nm. When the metal oxide particles are included in the diameter range, it is possible to prevent the occurrence of defects such as scratches and exhibit excellent dispersibility of the particles.

The surfactant of the present disclosure may be specifically selected from the group consisting of FS-30, FS-31, FS-34, ET-3015, ET-3150, ET-3050 from Chemourstm, and a mixture thereof, but is not particularly limited as long as it is a material that prevents carbon residues from being re-adsorbed on the surface of the semiconductor substrate during the polishing process.

The surfactant of the present disclosure is a nonionic surfactant, and a surfactant including a nonionic fluorine-based high molecular compound may be used alone or mixed with other nonionic surfactants.

The non-ionic surfactant may be selected from the group consisting of polyethylen glycol, polypropylene glycol, polyethylene-propylene copolymer, polyalkyl oxide, polyoxyethylene oxide (PEO), polyethylene oxide, and polypropylene oxide; and the fluorine-based surfactant may be selected from the group consisting of a sodium sulfonate fluorosurfactant, a phosphate ester fluorosurfactant, an amine oxide fluorosurfactant, a betaine fluorosurfactant, an ammonium carboxylate fluorosurfactant, a stearate ester fluorosurfactant, a quaternary ammonium fluorosurfactant, an ethylene oxide/-propylene oxide fluorosurfactant, and a polyoxyethylene fluorosurfactant.

The surfactant may be included in an amount of 0.001 parts by weight to 0.008 parts by weight, and 0.002 parts by weight to 0.005 parts by weight based on 100 parts by weight of the solvent. When the surfactant is mixed within the above range and used, dispersibility may be improved and re-adsorption of the polishing particles to the wafer surface may be

prevented.

The polishing composition of the present disclosure may further include a chelator. The chelator adsorbs metal or metal ions to facilitate removal. Specifically, there is a high possibility that metal, which may be generated during the polishing process, may be reattached to the polished surface or remain in a subsequent process to cause defects. In particular, a metal such as tungsten is relatively easily dissolved in a specific environment, but has a property being easily attached to the surface again, so a chelator may be applied as a sequestering agent to prevent this.

The chelator may include two or more carboxyl groups or alcohol groups in the molecule, and for example, may be selected from the group consisting of butyric acid, citric acid, tartaric acid, succinic acid, oxalic acid, acetic acid, adipic acid, capric acid, caproic acid, caprylic acid, carboxylic acid, glutaric acid, glutamic acid, glycolic acid, thioglycolic acid, formic acid, mandelic acid, fumaric acid, lactic acid, lauric acid, malic acid, maleic acid, malonic acid, myristic acid, palmitic acid, phthalic acid, isophthalic acid, terephthalic acid, citraconic acid, propionic acid, pyruvic acid, stearic acid, valeric acid, benzoic acid, phenylacetic acid, naphthoic acid, aspartic acid, amino acid, nitric acid, glycine, and ethylenediaminetetraacetic acid. The chelator is preferably selected from the group consisting of nitric acid, glycine, and a mixture thereof, but is not limited the above examples.

The chelator may be included in an amount of 0.1 parts by weight to 0.5 parts by weight, and 0.15 parts by weight to 0.4 parts by weigh, based on 100 parts by weight of the solvent. When the chelator is included within the above range, it is possible to exhibit an excellent polishing rate and prevent the occurrence of surface defects such as dishing.

The polishing composition of the present disclosure may include a pH adjuster. The pH adjuster may be any one selected from the group consisting of hydrochloric acid, phosphoric acid, sulfuric acid, hydrofluoric acid, nitric acid, hydrobromic acid, iodic acid, formic acid, malonic acid, maleic acid, oxalic acid, acetic acid, adipic acid, citric acid, adipic acid, acetic acid, propionic acid, fumaric acid, lactic acid, salicylic acid, pimelic acid, benzoic acid, succinic acid, phthalic acid, butyric acid, glutaric acid, glutamic acid, glycolic acid, lactic acid, aspartic acid, tartaric acid, and potassium hydroxide.

The pH adjuster may be included in an amount of 0.005 parts by weight to 0.05 parts by weight, 0.007 parts by weight to 0.03 parts by weight, and 0.009 parts by weight to 0.02 parts by weight based on 100 parts by weight of the solvent. The pH of the polishing composition for a semiconductor process may be 2 to 5, and preferably 2 to 4. When the acidic environment is maintained within the above range, excessive corrosion of metal components or polishing equipment may be prevented while maintaining the polishing rate and quality above a certain level.

The polishing composition for a semiconductor process includes a solvent as a remaining component except for each of the components described above and additional components to be described later. The solvent may be water, preferably ultrapure water is applied. The solvent may be included in the content range of the remainder of the content range of the polishing particles, the surfactant, the pH adjuster, and the chelator.

A method for manufacturing a semiconductor device according to another embodiment of the present disclosure includes: 1) providing a polishing pad including a polishing layer; 2) supplying a polishing composition for a semiconductor process to the polishing pad; and 3) polishing a polishing object while rotating the polishing object and the polishing layer relative to each other so that a polished surface of the polishing object is in contact with a polishing surface of the polishing layer, wherein the polishing composition contains polishing particles and a surfactant, 100 ml of the polishing composition is mixed and diluted with ultrapure water in a weight ratio of 1:30, and the diluted polishing composition has a value of 0.01 to 0.14 according to Equation 1 as measured by a large particle counter (LPC):

[Equation 1]

$$\frac{X \times 500A}{Y \times P}$$

wherein

X is the number of particles having a diameter of 1 μm or more as measured by LPC,

Y is the number of particles having a diameter of 0.7 μm or more as measured by LPC,

P is a weight part of the polishing particles based on the total weight of the polishing composition for a semiconductor process, and

A is a weight part of the surfactant based on the total weight of the polishing composition for a semiconductor process.

FIG. 3 is a schematic flowchart of a method for manufacturing of a semiconductor device according to an exemplary embodiment. Referring to FIG. 3, the polishing pad 110 according to the embodiment is mounted on a surface plate 120, a semiconductor substrate 130, which is an object to be polished, is disposed on the polishing pad 110. For polishing, a polishing slurry 150 is sprayed on the polishing pad 110 through a nozzle 140.

The flow rate of the polishing slurry 150 supplied through the nozzle 140 may be selected in the range of about 10 $cm^3$/min to about 1,000 $cm^3$/min depending on the purpose, and may be, for example, about 50 $cm^3$/min to about 500 $cm^3$/min, but is not limited thereto.

The polished surface of the semiconductor substrate 130 is in direct contact with the polishing surface of the polishing pad 110.

Thereafter, the semiconductor substrate 130 and the polishing pad 110 are rotated relative to each other, such that the surface of the semiconductor substrate 130 may be polished. In this case, a rotation direction of the semiconductor substrate 130 and a rotation direction of the polishing pad 110 may be the same as or be opposite to each other. Rotation speeds of the semiconductor substrate 130 and the polishing pad 110 may be selected according to a purpose in the range of about 10 rpm to about 500 rpm, respectively, and may be, for example, about 30 rpm to about 200 rpm, but is not limited thereto.

As an example of the substrate polishing process, in the case of a tungsten barrier metal layer CMP process, the substrate polishing may simultaneously appear three layers: a silicon oxide ($SiO_2$) layer and a titanium/titanium nitride layer used as a barrier metal layer as well as a tungsten (W) layer. The polishing composition for a semiconductor process of the present disclosure may be applied to a polishing process for a substrate in which the three layers appear simultaneously.

A detailed description of the polishing composition for a semiconductor process overlaps with the above description, and thus the description thereof will be omitted.

In one embodiment, the method for manufacturing a semiconductor device may further include processing the polishing surface of the polishing pad 110 through a conditioner 170 simultaneously with the polishing of the semiconductor substrate 130 in order to maintain the polishing surface of the polishing pad 110 in a state suitable for polishing.

**Preparation of semiconductor polishing composition**

Colloidal silica was used as polishing particles. The colloidal silica was reacted with 3-aminopropyltriethoxysilane as a surface modifier to prepare an amino silane compound to be bonded to the surface. The colloidal silica and the surface modifier were mixed in a weight ratio of 1:0.02 and reacted with each other.

A semiconductor polishing composition was prepared by using ultrapure water as a solvent, glycine as a chelator, acetic acid and silver nitrate as a pH adjuster, and s FS-30 from Chemourstm as a surfactant.

The composition was prepared by mixing in the range shown in Table 1 below based on 100 parts by weight of the solvent.

[Table 1]

| | Polishing particles | pH adjuster | Surfactant | Chelator |
|---|---|---|---|---|
| Example 1 | 3 | 0.01 | 0.002 | 0.25 |
| Example 2 | 3 | 0.01 | 0.005 | 0.25 |
| Example 3 | 4.5 | 0.01 | 0.005 | 0.25 |
| Example 4 | 3 | 0.01 | 0.001 | 0.25 |
| Comparative Example 1 | 3 | 0.01 | 0 | 0.25 |
| Comparative Example 2 | 3 | 0.01 | 0.01 | 0.25 |
| Comparative Example 3 | 3 | 0.01 | 0.002 | 0.5 |
| Comparative Example 4 | 3 | 0.025 | 0.002 | 0.25 |
| (Unit: parts by weight) | | | | |

**Experimental Example 1**

**Dispersion stability evaluation**

For the polishing compositions described in Examples and Comparative Examples, each sample was stored at 60°C using an air circulating oven. When the samples are stored for 1 hour under the condition of 60°C, the deterioration performance similar to that of storage at room temperature for 1 month may be expected, so they were stored for up to 12 hours using the air circulating oven.

5 ml of samples were collected every hour and particle size distribution was analyzed through Nano-ZS equipment from Malvern. In the case of particle size distribution, if the $D_{50}$ (average particle size) value increased by 5% or more, it was determined that the dispersion stability was broken and the experiment was stopped.

**LPC Measurement**

100 ml of each sample was prepared and aged at rest for 24 hours. The aged sample was diluted with ultrapure water in a weight ratio of 1:30 (sample: ultrapure water). Before sample measurement, the entire line of the instrument was washed with ultrapure water. With the following equipment and conditions, the diluted sample was measured 5 times or more, and the average value was calculated.

Instrument name: accusizer Fx Nano (PSSA)

Flow rate of diluent: 15 ml/min

Number of channels: 32

Light Extinction collection time: 60 seconds

Initial concentration: 4000/ml

Accordingly, values according to the following Equation 1 were also calculated:

[Equation 1]

$$\frac{X \times 500A}{Y \times P}$$

wherein

X is the number of particles having a diameter of 1 μm or more as measured by LPC,

X is the number of particles having a diameter of 0.7 μm or more as measured by LPC,

P is a weight part of the polishing particles based on 100 parts by weight of the solvent of the polishing composition for a semiconductor process,

A is a weight part of a surfactant based on 100 parts by weight of a solvent of the polishing composition for a semiconductor process.

The dispersion stability evaluation results and LPC measurement results are shown in Table 2 below.

[Table 2]

| | Dispersion stability (months) | 0.7 μm or more (ea) | 1 μm or more (ea) | Value of Equation 1 |
|---|---|---|---|---|
| Example 1 | 12 | 120 | 16 | 0.044 |
| Example 2 | 12 | 133 | 14 | 0.088 |

(continued)

| | Dispersion stability (months) | 0.7 μm or more (ea) | 1 μm or more (ea) | Value of Equation 1 |
|---|---|---|---|---|
| Example 4 | 5 | 187 | 64 | 0.057 |
| Comparative Example 1 | 4 | 244 | 122 | 0.000 |
| Comparative Example 2 | 12 | 173 | 101 | 0.973 |
| Comparative Example 3 | 5 | 744 | 331 | 0.148 |
| Comparative Example 4 | 3 | 199 | 133 | 0.223 |

As a result of the experiment on the polishing composition, it was confirmed that the composition corresponding to the Example of the present disclosure exhibited dispersion stability for 12 months or more, and the number of particles of 0.7 μm or more and particles of 1 μm or more was small even from the LPC measurement result.

Although not separately described in Table 2, in Example 3, the dispersion stability for 12 months was exhibited, which is excellent, and the number of particles having a diameter of 1 μm or more as measured by LPC was 143, and the number of particles having a diameter of 0.7 μm or more by LPC measurement was 266. This is because more polishing particles were included that other Examples and Comparative Examples, but as described later, it was confirmed that the polishing rate was excellent, the defect generation was also prevented, and microorganisms were not generated due to long-term storage.

On the other hand, in Example 4, it can be confirmed that the value according to Equation 1 was included within the scope of the present disclosure, but the dispersion stability for long-term storage was poor.

In the case of Comparative Example 1, it was confirmed that agglomeration between particles occurred and dispersion stability was poor because no surfactant was included.

In the case of Comparative Example 2, it can be confirmed that the dispersion stability was maintained for a long time as in the present disclosure, but a large amount of surfactant was included, so that a large amount of bubbles were generated when the polishing composition was prepared, and the composition of the Comparative Example 2 may not be used as a product.

Even in Comparative Examples 3 and 4, it was confirmed that dispersion stability was poor, and large particles were included in large amounts due to agglomeration between particles.

**Experimental Example 2**

(1) Polishing evaluation

A polishing evaluation was performed on a tungsten wafer having a thickness of about 5,000 Å and a silicon oxide layer wafer having a thickness of about 20,000 Å. Specifically, polishing was performed under conditions of a pressure of 15.2 kPa (2.2 psi) for 60 seconds, a carrier speed of 103 rpm, a platen speed of 57 rpm, and a slurry flow rate of 300 ml/min.

After the polishing process was performed, the thickness of each wafer was measured, and the polishing rate (polishing rate; A/min) of the tungsten layer and the silicon oxide layer of the slurry composition was calculated therefrom, respectively.

(2) Defect Measurement

After polishing under the same conditions as in the CMP evaluation, the cleaning process was performed using a self-prepared cleaning chemical solution under the conditions of a brush rotation speed of 500 rpm and a chemical spraying of 2000 cc/min for 60 s. For the tungsten and silicon oxide wafers that have undergone the cleaning process, the total defects were measured using AIT-XP+ equipment owned by SKC while sealed in a wafer foup.

[Table 3]

| | Polishing rate of Tungsten (Á/min) | Polishing rate of the silicon oxide layer (Å/min) | Defect on silicon oxide layer (ea) |
|---|---|---|---|
| Example 1 | 34 | 1235 | 71 |
| Example 2 | 37 | 1242 | 33 |

(continued)

| | Polishing rate of Tungsten (Å/min) | Polishing rate of the silicon oxide layer (Å/min) | Defect on silicon oxide layer (ea) |
|---|---|---|---|
| Example 3 | 87 | 1524 | 121 |
| Example 4 | 33 | 1278 | 342 |
| Comparative Example 1 | 29 | 1250 | 742 |
| Comparative Example 2 | 33 | 1221 | 84 |
| Comparative Example 3 | 174 | 1142 | 243 |
| Comparative Example 4 | 34 | 861 | 524 |

According to the experimental results, it can be confirmed that the Examples of the present disclosure exhibited a tungsten polishing rate and an excellent polishing rate of the silicon oxide layer, and showed low defects on the silicon oxide layer.

On the other hand, in the case of Comparative Examples 1 to 4, it was confirmed that a large number of defects appeared on the silicon oxide layer as compared with the Examples of the present disclosure.

**Experimental Example 3**

**Conform whether or not microorganism have occurred**

Each sample was treated at a concentration of 1 g on sterilized potato dextrose agar medium, and then cultured at 20°C for 14 days. Each sample was treated at a concentration of 1 g on sterilized trypicase soy agar medium, and then cultured at 20°C for 14 days. As shown in FIG. 1, when fungi and bacteria were not detected, it was indicated by X, and as shown in FIG. 2, when fungi and bacteria were detected, it was indicated by O.

The experimental results are shown in Table 4 below.

[Table 4]

| | Example 1 | Example 2 | Example 3 | Example 4 | Comp. Example 1 | Comp. Example 2 | Comp. Example 3 | Comp. Example 4 |
|---|---|---|---|---|---|---|---|---|
| Whether or not microorganism has occurred | X | X | X | O | O | X | O | X |

As shown in Table 4, in Examples 1 to 3 of the present disclosure, the inhibitory effect of fungi and bacteria was excellent.

On the other hand, it can be confirmed that when the surfactant of the present disclosure was not included or a small amount of surfactant was included, the inhibitory effect of fungi and bacteria was reduced and detected as shown in FIG. 2. In the case of Comparative Example 4, it was confirmed that the chelator was included in excess, resulting in poor dispersion stability, and thus the effect of inhibiting the occurrence of fungi and bacteria was reduced, and fungi and bacteria were detected as shown in FIG. 2.

**Claims**

**1.** A polishing composition for a semiconductor process, comprising polishing particles and a surfactant,

wherein 100 ml of the polishing composition is mixed and diluted with ultrapure water in a weight ratio of 1:30, and the diluted polishing composition has a value of 0.01 to 0.14 according to the following Equation 1 as measured by a large particle counter (LPC):

[Equation 1]

$$\frac{X \times 500A}{Y \times P}$$

wherein X is the number of particles having a diameter of 1 μm or more as measured by LPC,
Y is the number of particles having a diameter of 0.7 μm or more as measured by LPC,
P is a weight part of the polishing particles based on 100 parts by weight of the solvent of the polishing composition for a semiconductor process, and
A is a weight part of a surfactant based on 100 parts by weight of a solvent of the polishing composition for a semiconductor process.

**2.** The polishing composition for a semiconductor process of claim 1, wherein the polishing particles include a functional group bonded to the surface of the particles, and
the functional group includes a terminal amine group.

**3.** The polishing composition for a semiconductor process of claim 1 or 2, wherein the functional group bonded to the surface of the particles includes a structure of the following Formula 1:

[Formula 1]

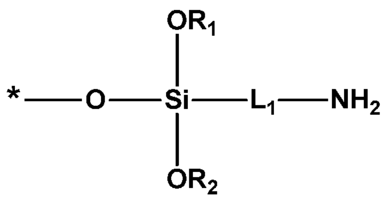

wherein * means a portion boned to the surface of the polishing particles,
$R_1$ and $R_2$ are the same as or different from each other, and are each independently selected from the group consisting of hydrogen, a substituted or unsubstituted alkyl group having 1 to 10 carbon atoms, a substituted or unsubstituted cycloalkyl group having 3 to 10 carbon atoms, a substituted or unsubstituted alkenyl group having 2 to 10 carbon atoms, and a substituted or unsubstituted alkynyl group having 2 to 10 carbon atoms, and
$L_1$ is selected from the group consisting of a substituted or unsubstituted alkylene group having 1 to 10 carbon atoms, a substituted or unsubstituted alkenylene group having 2 to 10 carbon atoms, a substituted or unsubstituted alkynylene group having 2 to 10 carbon atoms, and a substituted or unsubstituted cycloalkylene group having 3 to 10 carbon atoms

**4.** The polishing composition for a semiconductor process of any one of claims 1 to 3, wherein the polishing particles have amino silane bonded to the surface of the particles.

**5.** The polishing composition for a semiconductor process of claim 4, wherein amino silane is included in an amount of 0.15 to 0.3% by weight based on the total amount of the polishing composition for a semiconductor process.

**6.** The polishing composition for a semiconductor process of any one of claims 1 to 5, wherein the polishing particles are selected from the group consisting of metal oxides, organic particles, organic-inorganic composite particles, and a mixture thereof.

**7.** The polishing composition for a semiconductor process of any one of claims 1 to 6, wherein the polishing particles are included in an amount of 3 to 15% by weight based on the total amount of the polishing composition for a semiconductor process.

**8.** The polishing composition for a semiconductor process of any one of claims 1 to 7, wherein the surfactant is included in an amount of 0.001 to 0.008% by weight based on the total amount of the polishing composition for a semiconductor process; and wherein, when stored at 60°C for up to 12 hours in an air circulating oven, a change in a particle size distribution value of D50 is maintained at less than 5%.

**9.** The polishing composition for a semiconductor process of any one of claims 1 to 8, wherein the surfactant is included in an amount of 0.001 to 0.008% by weight based on the total amount of the polishing composition for a semiconductor process; and wherein, when cultured on potato dextrose agar medium or trypticase soy agar medium at 20°C for 14 days, fungi and bacteria are not detected.

**10.** The polishing composition for a semiconductor process of any one of claims 1 to 9, further comprising a chelator.

**11.** The polishing composition for a semiconductor process of any one of claims 1 to 11, further comprising a pH adjuster.

**12.** A method for manufacturing a semiconductor device, the method comprising:

1) providing a polishing pad including a polishing layer;
2) supplying a polishing composition for a semiconductor process to the polishing pad; and
3) polishing a polishing object while rotating the polishing object and the polishing layer relative to each other so that a polished surface of the polishing object is in contact with a polishing surface of the polishing layer,

wherein 100 ml of the polishing composition is mixed and diluted with ultrapure water in a weight ratio of 1:30, and
the diluted polishing composition has a value of 0.01 to 0.14 according to Equation 1 as measured by a large particle counter (LPC):

[Equation 1]

$$\frac{X \times 500A}{Y \times P}$$

wherein X is the number of particles having a diameter of 1 μm or more as measured by LPC,
Y is the number of particles having a diameter of 0.7 μm or more as measured by LPC,
P is a weight part of the polishing particles based on 100 parts by weight of the solvent of the polishing composition for a semiconductor process, and
A is a weight part of a surfactant based on 100 parts by weight of a solvent of the polishing composition for a semiconductor process.

**13.** The method of claim 12, wherein the polishing object is a tungsten wafer having a thickness of 5,000 Å, and the tungsten wafer is polished under the conditions of a pressure of 15.2 kPa (2.2 psi) for 60 seconds, a carrier speed of 103 rpm, a platen speed of 57 rpm, and supplying the polishing composition for a semiconductor process at a flow rate of 300 ml/min, and
the polishing rate for the tungsten layer in the polishing process is 30 to 100 A/min.

**14.** The method of claim 12 or 13, wherein the polishing object is a silicon oxide layer wafer having a thickness of 20,000 Å, and the silicon oxide layer wafer is polished under the conditions of a pressure of 15.2 kPa (2.2 psi) for 60 seconds, a carrier speed of 103 rpm, a platen speed of 57 rpm, and supplying the polishing composition for a semiconductor process at a flow rate of 300 ml/min, and
the polishing rate for the silicon oxide layer in the polishing process is 1,150 to 1,650 Å/min.

## Patentansprüche

**1.** Polierzusammensetzung für einen Halbleiterprozess, umfassend Polierpartikel und ein Tensid,

wobei 100 ml der Polierzusammensetzung mit ultrareinem Wasser in einem Gewichtsverhältnis von 1:30 vermischt und verdünnt werden, und
die verdünnte Polierzusammensetzung einen Wert von 0,01 bis 0,14 gemäß der folgenden Gleichung 1 aufweist, gemessen mit einem Partikelzähler für große Partikel (LPC):

[Gleichung 1]

$$\frac{X \times 500A}{Y \times P}$$

wobei X die Anzahl der Partikel mit einem Durchmesser von 1 μm oder mehr ist, gemessen mittels LPC,
Y die Anzahl der Partikel mit einem Durchmesser von 0,7 μm oder mehr ist, gemessen mittels LPC,
P ein Gewichtsanteil der Polierpartikel bezogen auf 100 Gewichtsteile des Lösungsmittels der Polierzusammensetzung für einen Halbleiterprozess ist, und
A ein Gewichtsanteil eines Tensids bezogen auf 100 Gewichtsteile eines Lösungsmittels der Polierzusammensetzung für einen Halbleiterprozess ist.

**2.** Polierzusammensetzung für einen Halbleiterprozess nach Anspruch 1, wobei die Polierpartikel eine an die Partikeloberfläche gebundene funktionelle Gruppe umfassen und die funktionelle Gruppe eine terminale Aminogruppe enthält.

**3.** Polierzusammensetzung für einen Halbleiterprozess nach Anspruch 1 oder 2, wobei die an die Oberfläche der Partikel gebundene funktionelle Gruppe eine Struktur der folgenden Formel 1 aufweist:

[Formel 1]

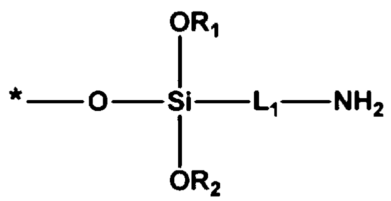

wobei * einen an die Oberfläche der Polierpartikel gebundenen Teil bedeutet, $R_1$ und $R_2$ gleich oder voneinander verschieden sind und jeweils unabhängig voneinander ausgewählt sind aus der Gruppe bestehend aus Wasserstoff, einer substituierten oder unsubstituierten Alkylgruppe mit 1 bis 10 Kohlenstoffatomen, einer substituierten oder unsubstituierten Cycloalkylgruppe mit 3 bis 10 Kohlenstoffatomen, einer substituierten oder unsubstituierten Alkenylgruppe mit 2 bis 10 Kohlenstoffatomen und einer substituierten oder unsubstituierten Alkinylgruppe mit 2 bis 10 Kohlenstoffatomen, und
$L_1$ ausgewählt ist aus der Gruppe bestehend aus einer substituierten oder unsubstituierten Alkylengruppe mit 1 bis 10 Kohlenstoffatomen, einer substituierten oder unsubstituierten Alkenylengruppe mit 2 bis 10 Kohlenstoffatomen, einer substituierten oder unsubstituierten Alkinylengruppe mit 2 bis 10 Kohlenstoffatomen und einer substituierten oder unsubstituierten Cycloalkylengruppe mit 3 bis 10 Kohlenstoffatomen.

**4.** Polierzusammensetzung für einen Halbleiterprozess nach einem der Ansprüche 1 bis 3, wobei die Polierpartikel an die Oberfläche der Partikel gebundenes Aminosilan aufweisen.

**5.** Polierzusammensetzung für einen Halbleiterprozess nach Anspruch 4, wobei Aminosilan in einer Menge von 0,15 bis 0,3 Gew.-% bezogen auf die Gesamtmenge der Polierzusammensetzung für einen Halbleiterprozess enthalten ist.

**6.** Polierzusammensetzung für einen Halbleiterprozess nach einem der Ansprüche 1 bis 5, wobei die Polierpartikel ausgewählt sind aus der Gruppe bestehend aus Metalloxiden, organischen Partikeln, organisch-anorganischen Verbundpartikeln und einem Gemisch davon.

**7.** Polierzusammensetzung für einen Halbleiterprozess nach einem der Ansprüche 1 bis 6, wobei die Polierpartikel in einer Menge von 3 bis 15 Gew.-% bezogen auf die Gesamtmenge der Polierzusammensetzung für einen Halbleiterprozess enthalten sind.

8. Polierzusammensetzung für einen Halbleiterprozess nach einem der Ansprüche 1 bis 7, wobei das Tensid in einer Menge von 0,001 bis 0,008 Gew.-% bezogen auf die Gesamtmenge der Polierzusammensetzung für einen Halbleiterprozess enthalten ist; und wobei bei Lagerung bei 60°C für bis zu 12 Stunden in einem Umluftofen eine Änderung des Partikelgrößenverteilungswerts D50 auf unter 5% gehalten wird.

9. Polierzusammensetzung für einen Halbleiterprozess nach einem der Ansprüche 1 bis 8, wobei das Tensid in einer Menge von 0,001 bis 0,008 Gew.-% bezogen auf die Gesamtmenge der Polierzusammensetzung für einen Halbleiterprozess enthalten ist; und wobei bei Kultivierung auf einem Kartoffel-Dextrose-Agar-Medium oder einem Trypticase-Soja-Agar-Medium bei 20°C über einen Zeitraum von 14 Tagen keine Pilze und Bakterien nachweisbar sind.

10. Polierzusammensetzung für einen Halbleiterprozess nach einem der Ansprüche 1 bis 9, weiterhin umfassend einen Chelatbildner.

11. Polierzusammensetzung für einen Halbleiterprozess nach einem der Ansprüche 1 bis 11, weiterhin umfassend ein pH-Einstellmittel.

12. Verfahren zur Herstellung einer Halbleitervorrichtung, wobei das Verfahren umfasst:

1) Bereitstellen eines Polierpads, das eine Polierschicht aufweist;
2) Zuführen einer Polierzusammensetzung für einen Halbleiterprozess zu dem Polierpad; und
3) Polieren eines Polierobjekts, während das Polierobjekt und die Polierschicht relativ zueinander gedreht werden, so dass eine polierte Oberfläche des Polierobjekts mit einer Polieroberfläche der Polierschicht in Kontakt steht,
wobei 100 ml der Polierzusammensetzung mit ultrareinem Wasser in einem Gewichtsverhältnis von 1:30 vermischt und verdünnt werden, und
die verdünnte Polierzusammensetzung einen Wert von 0,01 bis 0,14 gemäß Gleichung 1 aufweist, gemessen mittels eines Partikelzählers für große Partikel (LPC):

[Gleichung 1]

$$\frac{X \times 500A}{Y \times P}$$

wobei X die Anzahl der Partikel mit einem Durchmesser von 1 μm oder mehr ist, gemessen mittels LPC,
Y die Anzahl der Partikel mit einem Durchmesser von 0,7 μm oder mehr ist, gemessen mittels LPC,
P ein Gewichtsanteil der Polierpartikel bezogen auf 100 Gewichtsteile des Lösungsmittels der Polierzusammensetzung für einen Halbleiterprozess ist, und
A ein Gewichtsanteil eines Tensids bezogen auf 100 Gewichtsteile eines Lösungsmittels der Polierzusammensetzung für einen Halbleiterprozess ist.

13. Verfahren nach Anspruch 12, wobei das Polierobjekt ein Wolframwafer mit einer Dicke von 5.000 Å ist und der Wolframwafer unter den Bedingungen eines Drucks von 15,2 kPa (2,2 psi) für 60 Sekunden, einer Trägergeschwindigkeit von 103 U/min, einer Plattengeschwindigkeit von 57 U/min und unter Zufuhr der Polierzusammensetzung für einen Halbleiterprozess mit einer Durchflussrate von 300 ml/min poliert wird, und die Polierrate der Wolframschicht im Polierprozess 30 bis 100 Å/min beträgt.

14. Verfahren nach Anspruch 12 oder 13, wobei das Polierobjekt ein Siliziumoxidschicht-Wafer mit einer Dicke von 20.000 Å ist und der Siliziumoxidschicht-Wafer unter den Bedingungen eines Drucks von 15,2 kPa (2,2 psi) für 60 Sekunden, einer Trägergeschwindigkeit von 103 U/min, einer Plattengeschwindigkeit von 57 U/min und unter Zufuhr der Polierzusammensetzung für einen Halbleiterprozess mit einer Durchflussrate von 300 ml/min poliert wird, und die Polierrate der Siliziumoxidschicht im Polierprozess 1.150 bis 1.650 Å/min beträgt.

**Revendications**

**1.** Composition de polissage pour le traitement de semi-conducteurs, comprenant des particules de polissage et un tensioactif,

où 100 ml de la composition de polissage sont mélangés et dilués avec de l'eau ultrapure suivant un rapport pondéral de 1:30, et
la composition de polissage diluée a une valeur comprise entre 0,01 et 0,14 conformément à l'équation 1 suivante, mesurée par un compteur de grandes particules (LPC) :

[Équation 1]

$$\frac{X \times 500A}{Y \times P}$$

où X est le nombre de particules ayant un diamètre égal ou supérieur à 1 $\mu$m, tel que mesuré par le LPC,
Y est le nombre de particules ayant un diamètre égal ou supérieur à 0,7 $\mu$m, tel que mesuré par le LPC,
P est une partie en poids des particules de polissage sur la base de 100 parties en poids du solvant de la composition de polissage pour le traitement de semi-conducteurs, et
A est une partie en poids d'un tensioactif sur la base de 100 parties en poids d'un solvant de la composition de polissage pour le traitement de semi-conducteurs.

**2.** Composition de polissage pour le traitement de semi-conducteurs selon la revendication 1, où les particules de polissage comprennent un groupe fonctionnel lié à la surface des particules, et
où le groupe fonctionnel comprend un groupe amine terminal.

**3.** Composition de polissage pour le traitement de semi-conducteurs selon la revendication 1 ou la revendication 2, où le groupe fonctionnel lié à la surface des particules comprend une structure représentée par la formule 1 suivante :

[Formule 1]

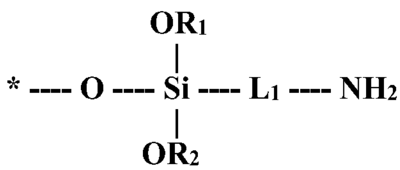

où * signifie une partie liée à la surface des particules de polissage,
R1 et R2 sont identiques ou différents l'un de l'autre, et sont sélectionnés indépendamment chacun dans le groupe comprenant de l'hydrogène, un groupe alkyle substitué ou non substitué ayant 1 à 10 atomes de carbone, un groupe cycloalkyle substitué ou non substitué ayant 3 à 10 atomes de carbone, un groupe alcényle substitué ou non substitué ayant 2 à 10 atomes de carbone, et un groupe alkynyle substitué ou non substitué ayant 2 à 10 atomes de carbone, et
L1 est sélectionné dans le groupe comprenant un groupe alkylène substitué ou non substitué ayant 1 à 10 atomes de carbone, un groupe alcénylène substitué ou non substitué ayant 2 à 10 atomes de carbone, un groupe alcynylène substitué ou non substitué ayant 2 à 10 atomes de carbone, et un groupe cycloalkylène substitué ou non substitué ayant 3 à 10 atomes de carbone

**4.** Composition de polissage pour le traitement de semi-conducteurs selon l'une des revendications 1 à 3, où les particules de polissage ont un aminosilane lié à la surface des particules.

**5.** Composition de polissage pour le traitement de semi-conducteurs selon la revendication 4, où l'aminosilane est compris en une teneur de 0,15 à 0,3 % en poids sur la base de la quantité totale de la composition de polissage pour le traitement de semi-conducteurs.

**6.** Composition de polissage pour le traitement de semi-conducteurs selon l'une des revendications 1 à 5, où les particules de polissage sont sélectionnées dans le groupe comprenant des oxydes métalliques, des particules organiques, des particules composites organiques-inorganiques et un mélange de ceux-ci.

7. Composition de polissage pour le traitement de semi-conducteurs selon l'une des revendications 1 à 6, où les particules de polissage sont comprises en une teneur de 3 à 15 % en poids sur la base de la quantité totale de la composition de polissage pour le traitement de semi-conducteurs.

8. Composition de polissage pour le traitement de semi-conducteurs selon l'une des revendications 1 à 7, où le tensioactif est compris en une teneur de 0,001 à 0,008 % en poids sur la base de la quantité totale de la composition de polissage pour le traitement de semi-conducteurs ; et où, en cas de stockage à 60 °C jusqu'à 12 heures dans un four à circulation d'air, une variation de la valeur de distribution de la taille des particules de D50 est maintenue inférieure à 5 %.

9. Composition de polissage pour le traitement de semi-conducteurs selon l'une des revendications 1 à 8, où le tensioactif est compris en une teneur de 001 à 0,008 % en poids sur la base de la quantité totale de la composition de polissage pour le traitement de semi-conducteurs ; et où, en cas de culture sur un milieu gélosé à base de dextrose à la pomme de terre ou un milieu gélosé à base de trypticase de soja à 20 °C pendant 14 jours, des champignons et des bactéries ne sont pas détectés.

10. Composition de polissage pour le traitement de semi-conducteurs selon l'une des revendications 1 à 9, comprenant en outre un chélateur.

11. Composition de polissage pour le traitement de semi-conducteurs selon l'une des revendications 1 à 11, comprenant en outre un correcteur d'acidité.

12. Procédé de fabrication d'un dispositif à semi-conducteur, ledit procédé comprenant :

1) le préparation d'un tampon de polissage présentant une couche de polissage ;
2) l'apport d'une composition de polissage pour le traitement de semi-conducteurs au tampon de polissage ; et
3) le polissage d'un objet à polir par rotation de l'objet à polir et de la couche de polissage l'un par rapport à l'autre de sorte qu'une surface polie de l'objet à polir est en contact avec une surface de polissage de la couche de polissage,
où 100 ml de la composition de polissage sont mélangés et dilués avec de l'eau ultrapure suivant un rapport pondéral de 1:30, et
la composition de polissage diluée a une valeur comprise entre 0,01 et 0,14 conformément à l'équation 1 suivante, mesurée par un compteur de grandes particules (LPC) :

[Équation 1]

$$\frac{X \text{ x } 500A}{Y \text{ x } P}$$

où X est le nombre de particules ayant un diamètre égal ou supérieur à 1 $\mu$m, tel que mesuré par le LPC,
Y est le nombre de particules ayant un diamètre égal ou supérieur à 0,7 $\mu$m, tel que mesuré par le LPC,
P est une partie en poids des particules de polissage sur la base de 100 parties en poids du solvant de la composition de polissage pour le traitement de semi-conducteurs, et
A est une partie en poids d'un tensioactif sur la base de 100 parties en poids d'un solvant de la composition de polissage pour le traitement de semi-conducteurs.

13. Procédé selon la revendication 12, où l'objet à polir est une plaquette de tungstène ayant une épaisseur de 5.000 Å, et la plaquette de tungstène est polie sous des conditions de pression de 15,2 kPa (2,2 psi) pendant 60 secondes, de vitesse de support de 103 tr/min, de vitesse de platine de 57 tr/min, et d'apport de la composition de polissage pour le traitement de semi-conducteurs avec un débit de 300 ml/min, et
où la vitesse de polissage pour la couche de tungstène lors du processus de polissage est comprise entre 30 et 100 Å/min.

14. Procédé selon la revendication 12 ou la revendication 13, où l'objet à polir est une plaquette de couche d'oxyde de silicium ayant une épaisseur de 20.000 A, et où ladite plaquette de couche d'oxyde de silicium est polie dans des conditions de pression de 15,2 kPa (2,2 psi) pendant 60 secondes, de vitesse de support de 103 tr/min, de vitesse de platine de 57 tr/min, et d'apport de la composition de polissage pour le traitement de semi-conducteurs avec un débit de 300 ml/min, et

où la vitesse de polissage pour la couche d'oxyde de silicium lors du processus de polissage est comprise entre 1.150 et 1.650 Å/min.

【FIG. 1】

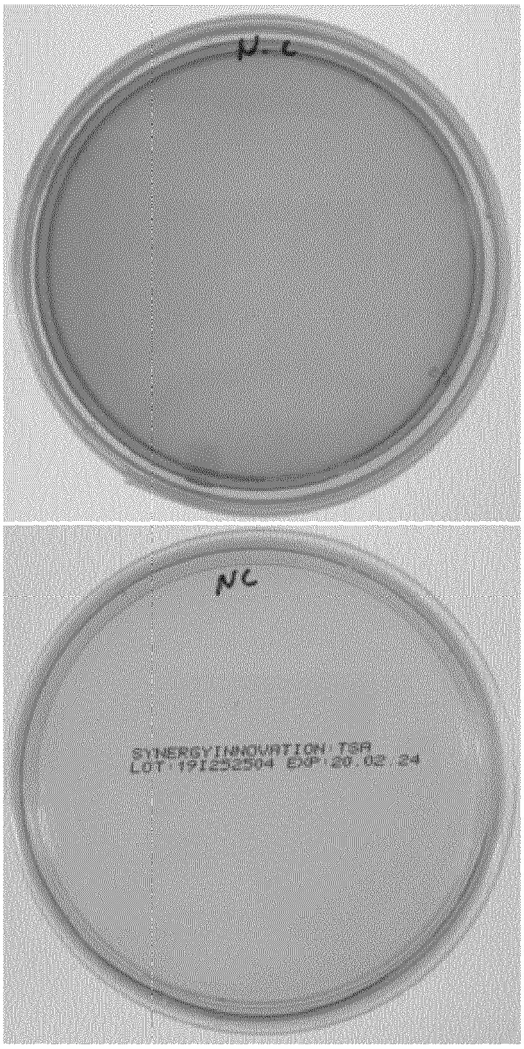

【FIG. 2】

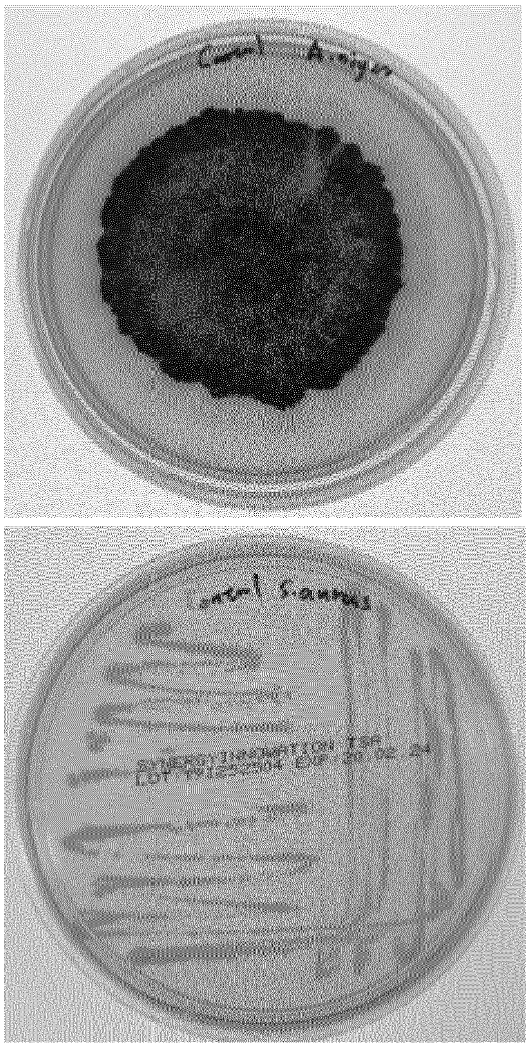

【FIG. 3】

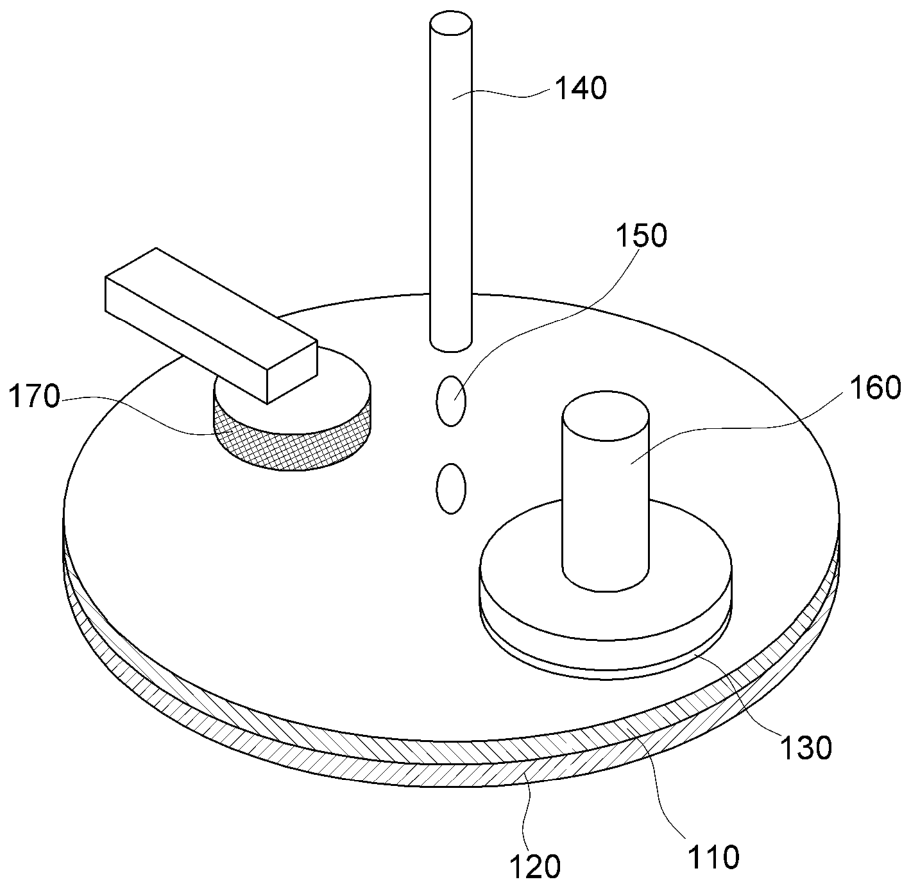

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2020172763 A1